# EUROPEAN PATENT APPLICATION

(11) **EP 4 468 009 A1**
(43) Date of publication of application: **27.11.2024**
(21) Application number: 23174533.2
(22) Date of filing: 22.05.2023
(51) Int. Cl.: G01R 33/54, G01R 33/561, G01R 33/567, G01R 33/28, G01R 33/483

(54) **MAGNETIC RESONANCE FINGERPRINTING FOR IMAGING DURING BREATH HOLDS**

(71) Applicant: Koninklijke Philips N.V., 5656 AG Eindhoven (NL)
(72) Inventor: LEE, Yoo Jin, Eindhoven (NL); DONEVA, Mariya Ivanova, Eindhoven (NL); KOKEN, Peter, 5656AG Eindhoven (NL); MEINEKE, Jan Jakob, Eindhoven (NL); HEUVELINK, Annerieke, Eindhoven (NL)
(74) Representative: Philips Intellectual Property & Standards

(57) **Abstract**

Disclosed herein is a medical system (100, 300) comprising a memory (110) storing machine executable instructions (112) and a pulse sequence database (114). The pulse sequence database comprises magnetic resonance fingerprinting pulse sequences (604, 1000, 1002). The execution of the machine executable instructions causes a computational system (104) to: receive (200) calibration respiratory data (116) descriptive of multiple respiratory phases of a subject (322); identify (202) breath hold data portions (118); identify (204) active breathing data portions (120); determine (206) a subject specific breath hold duration (122) using the breath hold data portions; determine (208) a subject specific active breathing duration (124) using the active breathing portions; and select (210) a selected magnetic resonance fingerprinting pulse sequence (126) and a selected magnetic resonance fingerprinting dictionary (128) from the pulse sequence database using the subject specific breath hold duration and the subject specific active breathing duration.

## Description

### FIELD OF THE INVENTION

The invention relates to magnetic resonance imaging, in particular to magnetic resonance imaging fingerprinting.

### BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field. Various quantities or properties of the subject can be measured spatially using MRI. A newer MRI technique is Magnetic Resonance Fingerprinting (MRF).

International patent application publication WO 2012/049634 A1 discloses systems, devices, and methods for performing a magnetic resonance imaging scan of a patient. For example, a method of performing a magnetic resonance imaging scan on a patient can include monitoring a physiological signal level of the patient, analyzing the monitored physiological signal level, and providing instruction to the patient and/or changing the environmental conditions exposed to the patient. The instructions and/or the change of the environmental conditions of the patient can be based on the monitored physiological signal level. The instructions can include an acoustic command and/or a visual command. The changing of the environment conditions can include visual simulations, acoustic simulations and/or air conditioning change.

### SUMMARY OF THE INVENTION

The invention provides for a medical system, a method, and a computer program in the independent claims. Embodiments are given in the dependent claims.

In one aspect the invention provides for a medical system that comprises a memory storing machine-executable instructions and a pulse sequence database. A pulse sequence as used herein may be understood as encompassing a set of commands configured for controlling a magnetic resonance imaging system to acquire k-space data or data which may be converted into such commands. For example, typically pulse sequences are represented in the form of a timing diagram. The pulse sequence database comprises magnetic resonance fingerprinting pulse sequences. The magnetic resonance fingerprinting pulse sequences within the pulse sequence database are configured to acquire the k-space data discontinuously and have different acquisition durations and different respiratory cycle durations.

During the motion of a subject going through a respiratory cycle the location of the subject's abdomen may change. Acquiring data during motion of the subject may then lead to a blurring or artifacts in the resulting magnetic resonance images reconstructed from the k-space data. By breaking the acquisition of the k-space into discontinuous portions, the acquisition of the k-space data can be acquired when the subject is not moving. For example, when the subject has exhaled and is holding the exhale position. A respiratory cycle duration, as used herein, may encompass the duration to complete a complete respiratory cycle including inhalation and exhalation.

The medical system further comprises a computational system. Execution of the machine-executable instructions causes the computational system to receive calibration respiratory data descriptive of multiple respiratory phases of a subject. The calibration respiratory data may include data on the position or respiratory phase of a subject as a function of time. Execution of the machine-executable instructions further causes the computational system to identify breath hold portions in the calibration respiratory data. For example, the calibration respiratory data may be used to identify periods where the subject has exhaled and is holding this exhale position. The breath hold position is particularly advantageous for acquiring k-space data. A subject may for example either hold the position in exhale or in inhale position. The exhale position is typically superior because when the subject inhales the subject may inhale a different amount of air each time. Holding the exhale position may be more regular and reproducible during the acquisition of the k-space data.

Execution of the machine-executable instructions further causes the computational system to identify active breathing data portions in the calibration respiratory data. Pairs of the active breathing data portions and the breath hold data portions form one respiratory cycle duration of the subject. Execution of the machine-executable instructions further causes the computational system to determine a subject-specific breath hold duration using the breath hold data portions. Execution of the machine-executable instructions further causes the computational system to determine a subject-specific active breathing duration using the active breathing portions. The determination of the subject-specific breath hold duration and the subject-specific active breathing duration may for example be determined using statistical calculations.

Execution of the machine-executable instructions further causes the computational system to select a selected magnetic resonance fingerprinting pulse sequence and a selected magnetic resonance fingerprinting dictionary from the pulse sequence database using the subject-specific breath hold duration and the subject-specific active breathing duration. The selected magnetic resonance fingerprinting pulse sequence and the selected magnetic resonance fingerprinting dictionary is selected such that the acquisition duration is shorter than or equal to the subject-specific breath hold duration.

This embodiment may be advantageous because the magnetic resonance fingerprinting pulse sequence and its associated magnetic resonance fingerprinting dictionary are selected from pre-calculated pulse sequences in the pulse sequence database. The advantage of this may be that the magnetic resonance fingerprinting dictionary for the selected magnetic resonance fingerprinting pulse sequence is available immediately. This means that the k-space data can be acquired directly for the subject and then the data can be reconstructed into images using a magnetic resonance fingerprinting protocol. If the magnetic resonance fingerprinting dictionary were not pre-calculated, then computationally intensive calculations would need to be made to calculate the selected magnetic resonance fingerprinting dictionary. This for example could be calculated using the so-called Bloch equation.

Embodiments may enable the accurate imaging of the subject without a delay in producing magnetic resonance images.

A difficulty in performing magnetic resonance fingerprinting (MRF) imaging of a subject is that respiratory motion can corrupt or blur the images. In conventional magnetic resonance imaging the acquisition of the k-space data can be gated such that k-space data is only acquired during particular respiratory phases or during a breath hold. This approach is more difficult in MRF.

In MRF there is an evolving pulse sequence where various pulse sequence parameters are varied, and multiple images are acquired. For each voxel a vector may be constructed using these multiple images. A knowledge of the pulse sequence used to acquire the k-spaced data may be used to construct a so-called dictionary, typically using the Bloch equation, which contains vectors for different physical properties such as relaxation times or tissue composition. A matching of the measured vector for each voxel to this dictionary allows quantitative maps or even synthetic magnetic resonances to be constructed. If the MRF pulse sequence is interrupted, as would be the case for abdominal imaging, then the dictionary would no longer be valid. This may require a recalculation of the magnetic resonance fingerprinting dictionary which may be time consuming and computationally intensive.

Embodiments may provide for a means of accelerating this by first measuring calibrations respiratory data of a subject and then using this to determine a subject specific breath hold duration and a subject specific active breathing duration. These values or their equivalents may be then used to retrieve a selected magnetic resonance imaging fingerprinting dictionary and its paired selected magnetic resonance fingerprinting dictionary from a pulse sequence database. This may enable the measurement of the k-space data and the rapid calculation of magnetic resonance images very rapidly.

The subject-specific breath hold duration may for example be the most likely duration or the average breath hold duration. Likewise, the subject-specific active breathing duration may be the most likely active breathing duration, or it may also be the average active breathing duration of the subject.

In other examples the subject-specific breath hold duration and the subject-specific active breathing duration may be modified such that their duration is longer than the average or most likely values. For example, in experiments, most subjects were able to comfortably follow a displayed breathing pattern for an extended time period (long enough to cover one MRF scan) with a 1 to 2 seconds longer breath hold duration than their normal exhale hold duration. Extending these durations by several seconds may result in faster scans. Many subjects have a natural breathing cycle with a breath hold duration that lasts 0.5 seconds to 2.5 seconds on average. On average these subjects were able to extend the breath hold duration between 4.5 to 5 seconds comfortably.

The subject-specific breath hold duration may therefore, in some examples, be the most likely breath hold duration or the average breath hold duration of the subject plus a predetermined extension.

In some further examples, the predetermined extension may for example be between 0.5 and 5 seconds, preferably between 1 and 3 seconds.

By guiding the subject to an adapted pattern with extended breath hold duration the scan efficiency can be increased. The scan starts after a fixed breathing pattern (resembling the subject-specific active breathing duration plus the subject-specific breath hold duration) whose magnetic resonance fingerprinting dictionary will be selected for reconstruction is reached.

The extension added to the breath hold duration seen in unguided natural breathing to come to a subject-specific breath hold duration for the guided breathing can be determined before the examination or in real-time. To ensure a desired extension from the perspective of scan efficiency fits the patient, it could be evaluated beforehand by offering a breathing guidance session / exercise at home or in the waiting room while monitoring the patient execution. Alternatively, this extension could be evaluated and determined in real-time by stepwise prolonging the natural breath hold duration with the desired extension using breathing guidance. Upon reaching a stable breathing pattern the scan will start and the reconstruction will happen using the magnetic resonance fingerprinting dictionary that matches the guided breathing pattern (resembling the subject-specific active breathing duration plus the subject-specific breath hold duration).

The active breathing data portions may encompass the portions when the subject is not holding the breath in the breath hold position or when the subject's diaphragm is moving.

MRF is a technique which allows the simultaneous measurement of MR parameters such as T1, T2, and other parameters as well as quantitative tissue properties such as the fractional quantity of different tissue types within a voxel. In MRF a pulse sequence may be used where various parameters such as the flip angle, TE, and TR are systematically varied. In a simplified example, the k-space data is repeatedly acquired during the execution of the pulse sequence and a series of images are reconstructed. A vector or "fingerprint" comprising the value of the voxel from each of the series of images is constructed. This vector or fingerprint is then compared to a dictionary of fingerprints for various MR parameters and for different tissue properties. The vector or "fingerprint" is referred to herein as MRF data. The MRF data may be either the series of images or the vector form of the data. As described herein references to the reconstruction of a magnetic resonance image from k-space data and a magnetic resonance fingerprinting dictionary may implicitly include the process of constructing the vectors or fingerprints for each voxel and comparing them or performing matching to a magnetic resonance fingerprinting dictionary.

In another embodiment the medical system further comprises a respiratory monitoring system configured for measuring respiratory data descriptive of a respiratory phase of the subject. The medical system further comprises a magnetic resonance imaging system that is configured for acquiring k-space data descriptive of the subject from an imaging zone. Execution of the machine-executable instructions further causes the computational system to acquire the k-space data by controlling the magnetic resonance imaging system with the selected magnetic resonance fingerprinting pulse sequence. Execution of the machine-executable instructions further causes the computational system to measure the respiratory data during acquisition of the k-space data. Execution of the machine-executable instructions further causes the computational system to determine the respiratory phase of the subject using the respiratory data. The acquisition of the k-space data is synchronized to the respiratory phase of the subject.

As the selected magnetic resonance fingerprinting pulse sequence was selected using the subject's own subject-specific breath hold duration and subject-specific active breathing duration the subject is able to easily maintain this breathing rate. When the breath hold duration does not match what the subject can do comfortably, then it may be that the subject would need recovery time in between acquisition of k-space data while the subject is recovering their breathing rhythm. This embodiment may therefore be advantageous because it enables more rapid acquisition of the k-space data.

In another embodiment execution of the machine-executable instructions further causes the computational system to control the respiratory monitoring system to acquire the calibration respiratory data from the subject.

In another embodiment execution of the machine-executable instructions further causes the computational system to control the magnetic resonance imaging system to move the subject into the magnetic resonance imaging system before acquiring the calibration respiratory data. The magnetic resonance imaging system further comprises a magnetic gradient coil system. Execution of the machine-executable instructions preferably causes the computational system to repeatedly activate the magnetic gradient coil system during measurement of the calibration respiratory data. Moving the subject into the bore of the magnet of the magnetic resonance imaging system may be advantageous because the subject may find it stressful to be within the magnetic resonance imaging system. Placing the subject within the bore may then have an effect on the breathing rhythm of the subject.

Obtaining the calibration of the subject's breathing rhythm may therefore be advantageous after the subject has been moved into the magnetic resonance imaging system. Likewise, the gradient coil system of the magnetic resonance imaging system may be quite noisy. This may have an effect on the stress level of the subject and may therefore affect the breathing rate. The activation of the magnetic gradient coil system typically encompasses having the magnetic field of the gradient coil changing rapidly as would be performed during the acquisition of k-space data so that the subject is subjected to auditory noise in a similar fashion. Doing this during the measurement of the calibration respiratory data may be beneficial because it may be more similar to the conditions when the k-space data is acquired.

In another embodiment execution of the machine-executable instructions further causes the computational system to measure the calibration respiration data using the respiration monitoring system at least partially during a pre scan operation of the magnetic resonance imaging system. For example, the calibration respiration data could be acquired during a few seconds of calibration (for resonance frequency determination, RF power calibration, etc.). Alternatively, it can be measured also during free-breathing transmit B 1 map scan, that we normally acquire before MRF scans to correct for the inhomogeneous transmit B 1 field effects at high-field systems (e.g. 3T). This embodiment may be beneficial because of the presence of auditory noise similar to that when the k-space data is measured as well as being a typically normal part of a magnetic resonance imaging examination. The respiratory monitoring could be performed at this time and this would maybe reduce the delay for the amount of time for the complete examination.

In another embodiment the medical system further comprises a subject user interface configured for use by the subject during the acquisition of the k-space data.

In another embodiment the medical system further comprises a subject audio system configured to provide auditory signals to the subject. The subject audio system may for example provide headphones for the subject. In some examples the subject audio system provides noise cancelling headphones so that gradient coil and other noise does not interfere with any audio signals provided to the subject by the subject audio signal.

In another embodiment execution of the machine-executable instructions further causes the computational system to render a breathing guide using the subject user interface, which is configured to alternatively render a breath hold indicator for the subject-specific breath hold duration and active breathing indicator for the subject-specific active breathing duration. Execution of the machine-executable instructions further causes the acquisition of the k-space data to be synchronized with the rendering of the breath hold indicator. Breath hold indicator and the active breathing indicator could be provided by auditory and/or visual signals provided to the subject.

In another embodiment the medical system further comprises a subject display visible by the subject during the acquisition of the k-space data. The subject user interface could for example comprise the subject display. The subject user interface could for example comprise the subject audio signal. In some examples the subject user interface could comprise both the subject display and the subject audio system.

This may, for example, be a projector and mirror used to provide the subject display or even a magnetic resonance imaging-compatible display.

In another embodiment execution of the machine-executable instructions further causes the computational system to display a breathing guide, which is configured to alternatively display a breath hold indicator display for the subject-specific breath hold duration and active breathing indicator display for the subject-specific active breathing duration. Execution of the machine-executable instructions further causes the acquisition of the k-space data to be synchronized with the display of the breath hold indicator.

In another embodiment, the breathing guide comprises a continuous and alternating chain of breath hold indicators and active breathing indicators moving past an indicator or marker.

In another embodiment, execution of the machine executable instructions further causes the computational system to determine a current breath hold duration of the subject and a current active breathing duration using the respiratory data. Execution of the machine executable instructions further causes the computational system to perform a step wise adjustment of the rendering of the breath hold indicator and the active breathing indicator such that the current breath hold duration matches the subject specific breath hold duration and such that the current active breathing duration matches the subject specific active breathing duration.

This may be beneficial in several situations. Prior beginning of the acquisition of the k-space data the step wise adjustment of the rendering of the breath hold indicator so that the subject is synchronized to the subject specific breath hold duration and the subject specific active breathing duration. For example, the subject specific breath hold duration could be formed by adding a predetermined extension to the current breath hold duration to increase the efficiency of the acquisition of k-space data. The step wise adjustment of the rendering of the breath hold indicator could be used to ease the subject into the longer breath hold instead of just imposing the longer breath hold.

This may also be useful in the situation where the subject's breathing is no longer synchronized with the subject user interface. The step wise adjustment of the rendering of the subject user interface could be used to bring the subject back to the proper breathing.

In another embodiment, execution of the machine-executable instructions further causes the computational system to continuously measure the respiratory data from the subject. Execution of the machine-executable instructions further causes the computational system to trigger acquisition of the k-space data when the subject is detected as reaching a held respiratory phase such as a held exhale position. This may be a means of increasing the accuracy of measuring the k-space data during the breath hold of the subject.

In another embodiment, the pulse sequence database comprises magnetic resonance fingerprint dictionaries paired with the magnetic resonance fingerprinting pulse sequence. Execution of the machine-executable instructions further cause the computational system to reconstruct a magnetic resonance image from the k-space data and the selected magnetic resonance fingerprinting dictionary.

In another embodiment, execution of the machine-executable instructions further causes the computational system to construct a set of different acquisition durations and different respiratory cycle durations. Execution of the machine-executable instructions further causes the computational system to construct a magnetic resonance fingerprinting pulse sequence for each combination of the different acquisition durations and different respiratory cycle durations. Execution of the machine-executable instructions further cause the computational system to calculate a magnetic resonance fingerprinting dictionary for each magnetic resonance fingerprinting pulse sequence constructed for each of the different acquisition durations and different respiratory cycle durations. Execution of the machine-executable instructions further causes the computational system to store the magnetic resonance fingerprinting dictionary for each magnetic resonance fingerprinting pulse sequence constructed for each of the different acquisition durations and different respiratory cycle durations in the pulse sequence database.

In another embodiment, the respiratory monitoring system comprises a respiratory belt.

In another embodiment, the respiratory monitoring system comprises a breathing tube flow monitor.

In another embodiment, the respiratory monitoring system comprises a camera system.

In another embodiment, the respiratory monitoring system is implemented by a motion detection system independent of a magnetic resonance image acquisition. For example, a pilot tone navigator may be used as the pilot tone navigator uses a constant radio-frequency signal transmitted into the scanner to encode physiological motion. A pilot tone would not necessitate the modification of the pulse sequences. This may have the advantage that the use of a pilot tone does not add any overhead or cause any increase in the acquisition time.

In another embodiment, the selected magnetic resonance fingerprinting pulse sequence is configured for performing a multi-slice acquisition using a slice-by-slice acquisition of the k-space data.

In another embodiment, the selected magnetic resonance fingerprinting pulse sequence is configured for performing a multi-slice acquisition using an interleaved acquisition of the k-space data.

In another aspect, the invention provides for a method of constructing a pulse sequence database. The method comprises constructing a set of different acquisition durations and different respiratory cycle durations. The method further comprises constructing a magnetic resonance fingerprinting pulse sequence for each combination of the different acquisition durations and different respiratory cycle durations. The method further comprises calculating a magnetic resonance fingerprinting dictionary for each magnetic resonance fingerprinting pulse sequence constructed for each of the different acquisition durations and different respiratory cycle durations. The method further comprises storing the magnetic resonance fingerprinting dictionary for each magnetic resonance fingerprinting pulse sequence constructed for each of the different acquisition durations and different respiratory cycle durations in the pulse sequence database. The construction of the magnetic resonance fingerprinting dictionary may, for example, be performed by taking the various magnetic resonance fingerprinting pulse sequences and then using the Bloch equation.

In other aspect, the invention provides for a computer program comprising machine-executable instructions and a pulse sequence database. The pulse sequence database comprises magnetic resonance fingerprinting pulse sequences. The magnetic resonance fingerprinting pulse sequences within the pulse sequence database are configured to acquire the k-space data discontinuously and have different acquisition durations and different respiratory cycle durations. Execution of the machine-executable instructions causes the computational system to receive calibration respiratory data descriptive of multiple respiratory phases of the subject. Execution of the machine-executable instructions further causes the computational system to identify breath hold portions in the calibration respiratory data. Execution of the machine-executable instructions further causes the computational system to identify active breathing data portions in the calibration respiratory data. Pairs of the active breathing data portions and the breath hold data portions form one respiratory cycle duration of the subject.

Execution of the machine-executable instructions further causes the computational system to determine a subject-specific breath hold duration during the breath hold data portions. Execution of the machine-executable instructions further causes the computational system to determine a subject-specific active breathing duration using the active breathing portions. Execution of the machine-executable instructions further causes the computational system to select a selected magnetic resonance fingerprinting pulse sequence and a selected magnetic resonance fingerprinting dictionary from the pulse sequence database using the subject-specific breath hold duration and the subject-specific active breathing duration. The selected magnetic resonance fingerprinting pulse sequence and the selected magnetic resonance fingerprinting dictionary is selected such that the acquisition duration is shorter than or equal to the subject-specific breath hold duration.

The advantages of this have been previously discussed.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data.

A Magnetic Resonance Imaging (MRI) image or MR image is defined herein as being the reconstructed two- or three-dimensional visualization of anatomic data contained within the k-space data. This visualization can be performed using a computer. As used here a magnetic resonance image reconstructed from k-space data and a magnetic resonance imaging fingerprinting dictionary encompasses both a map (such as a quantitative map) or a synthetic magnetic resonance image.

### BRIEF DESCRIPTION OF THE DRAWINGS

In the following preferred embodiments of the invention will be described, by way of example only, and with reference to the drawings in which:
Fig. 1 illustrates an example of a medical system;
Fig. 2 shows a flow chart which illustrates a method of using the medical system of Fig. 1;
Fig. 3 illustrates a further example of a medical system;
Fig. 4 shows a flow chart which illustrates a method of using the medical system of Fig. 3;
Fig. 5 shows a flow chart which illustrates a method of constructing a pulse sequence database;
Fig. 6 shows an exemplary magnetic resonance fingerprinting flip angle train from a magnetic resonance fingerprinting pulse sequence;
Fig. 7 illustrates an example of a breathing guide;
Fig. 8 shows a further example of a method;
Fig. 9 illustrates the division of a pulse sequence train for a magnetic resonance fingerprinting pulse sequence; and
Fig. 10 illustrates two magnetic resonance fingerprinting pulse sequences.

### DESCRIPTION OF EMBODIMENTS

Like numbered elements in these figures are either equivalent elements or perform the same function. Elements which have been discussed previously will not necessarily be discussed in later figures if the function is equivalent.

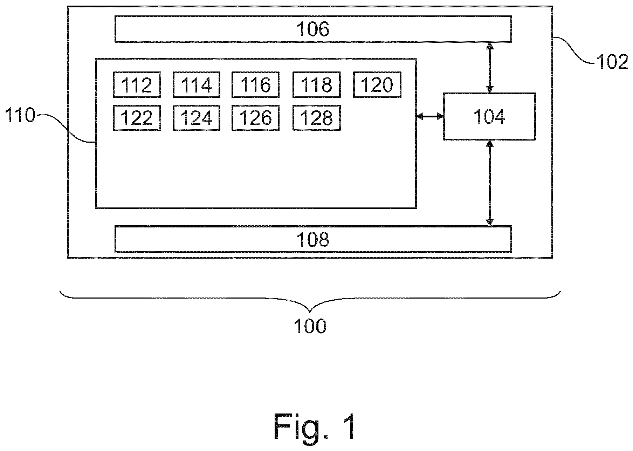

Fig. 1 illustrates an example of a medical system 100. The medical system 100 is shown as comprising a computer 102 that comprises a computational system 104. The computer is intended to represent one or more computer systems that may or may not be networked. The computational system 104 is intended to represent one or more processors or computational systems which may be located at one or more locations. The medical system 100, as depicted in Fig. 1, may be implemented in different ways in different examples. In one example, it may be available as a remote service via the internet, for example, as a cloud-based application. In other examples, it may be integrated into the control system or other components of a magnetic resonance imaging system. The computational system 104 is shown as being in communication with an optional network interface 106 or hardware interface. The network or hardware interface 106 may, for example, be used to communicate with other computer systems. In other examples, it may be used to send messages to control and exchange data with other components if the medical system 100 comprises them.

The computational system 104 is further shown as being in communication with an optional user interface 108. The user interface 108 may, for example, provide a means for an operator to operate and control the medical system 100. The computational system 104 is in further communication with a memory 110. The memory 110 is intended to represent various types or a conglomeration of volatile and non-volatile memories. In some examples, the memory 110 is a non-transitory storage medium.

The memory 110 is shown as containing machine-executable instructions 112. The machine-executable instructions 112 provide instructions which enable the computational system 104 to perform such tasks as controlling other components as well as performing the various image processing and/or numerical tasks. The memory 110 is further shown as containing a pulse sequence database 114 that comprises pairs of magnetic resonance fingerprinting pulse sequences and magnetic resonance fingerprinting dictionaries. The pairs of pulse sequences and dictionaries are indexed by their breath hold duration and subject-specific active breathing duration. The breath hold duration and the subject-specific active breathing duration comprise one respiratory cycle. So, for example, the pulse sequence database 114 may also be indexed according to the breath hold duration and the entire respiratory cycle duration.

The memory 110 is further shown as containing calibration respiratory data 116 that has been received for a subject and is descriptive of multiple respiratory cycles of the subject. The memory 110 is further shown as containing active breathing data portions 120 and subject-specific breath hold durations 122. These were constructed by dividing the breath hold data portions 118 into these components. The memory 110 is further shown as containing a subject-specific breath hold duration that was calculated from the breath hold data portions 118. The memory 110 is further shown as containing a subject-specific active breathing duration 124 that was calculated from the active breathing data portions 120. These durations 122, 124 may for example be calculated using averages or, in other examples, using the most likely value.

The memory is further shown as containing a selected magnetic resonance fingerprinting sequence 126 that has been paired with a selected magnetic resonance fingerprinting dictionary 128 that has been retrieved from the pulse sequence database 114 using the subject-specific breath hold duration 122 and the subject-specific active breathing duration 124.

A database, as used herein, may encompass a collection of files which are accessible according to their breath hold duration and active breathing duration 124. In other examples the database may also be a relational database.

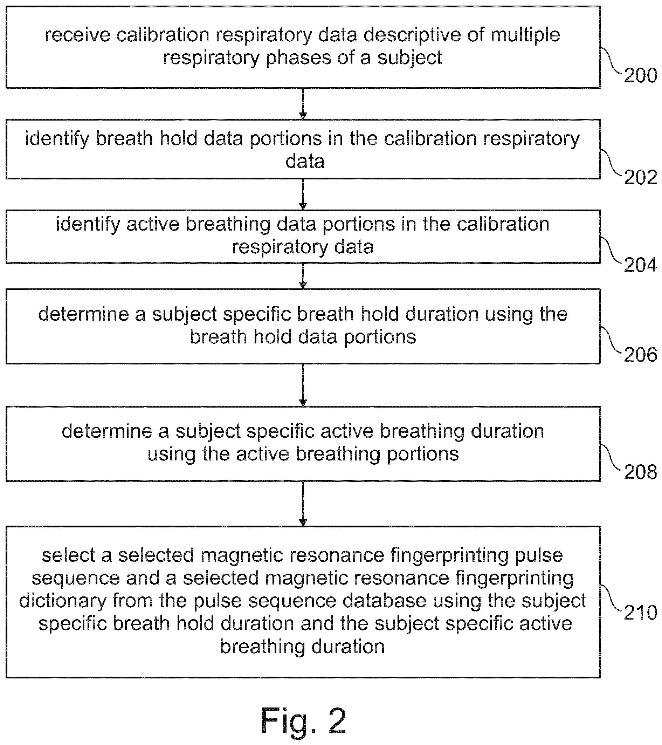

Fig. 2 shows a flowchart which illustrates a method for operating the medical system 100 of Fig. 1. In, step 200, the calibration respiratory data 116 is received. In step 202, the breath hold data portions 118 are identified in the calibration respiratory data 116. In step 204, the active breathing data portions 120 are identified in the calibration respiratory data 116. As was mentioned before, pairs of the active breathing data portions 120 and the breath hold data portions 118 form one respiratory cycle duration of the subject. In step 206, the subject-specific breath hold duration 122 is determined using the breath hold data portions 118.

In step 208, the subject-specific active breathing duration 124 is determined using the active breathing data portions 120. In step 210, the selected magnetic resonance fingerprinting sequence 126 and the selected magnetic resonance fingerprinting dictionary 128 are retrieved from the pulse sequence database 114 using the subject-specific breath hold duration 122 and the subject-specific active breathing duration 124.

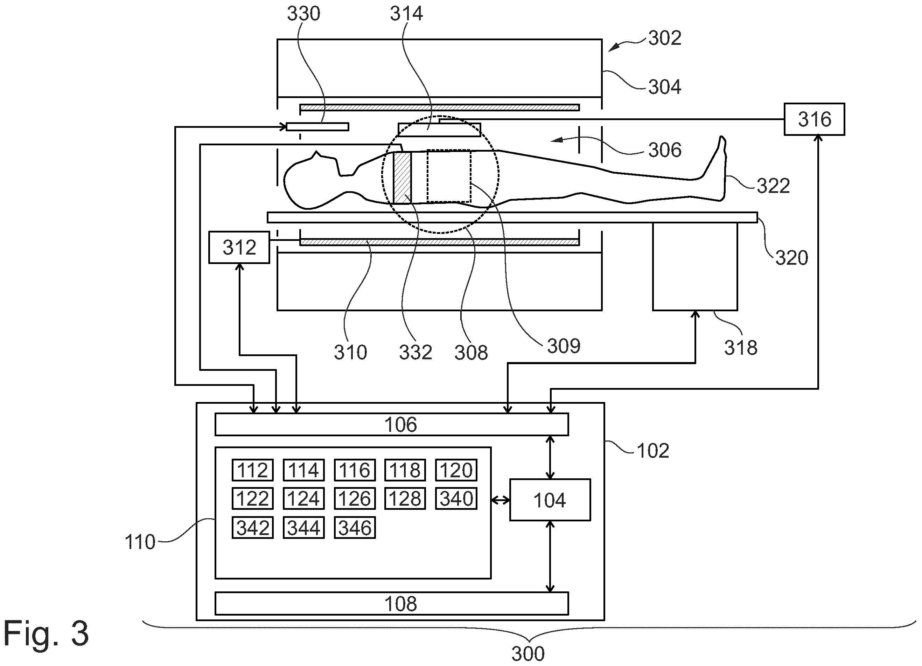

Fig. 3 illustrates a further example of a medical system 300. The medical system 300 is similar to that depicted in Fig. 1 except that it additionally comprises a magnetic resonance imaging system 302.

The magnetic resonance imaging system 302 comprises a magnet 304. The magnet 304 is a superconducting cylindrical type magnet with a bore 306 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 306 of the cylindrical magnet 308 there is an imaging zone 308 where the magnetic field is strong and uniform enough to perform magnetic resonance imaging. A field of view 309 is shown within the imaging zone 308. The magnetic resonance data is typically acquired for a field of view 309. The subject 322 is shown as being supported by the subject support 322 such that at least a portion of the subject 322is within the imaging zone 308 and the field of view 309. In some examples there may be a subject support actuator 318 that may be used to move the subject support 320 so as to move the subject 322 into the bore 306 of the magnet 304.

Within the bore 306 of the magnet there is also a set of magnetic field gradient coils 310 which is used for acquisition of preliminary magnetic resonance data to spatially encode magnetic spins within the imaging zone 308 of the magnet 304. The magnetic field gradient coils 310 connected to a magnetic field gradient coil power supply 312. The magnetic field gradient coils 310 are intended to be representative. Typically, magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio-frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio-frequency coil 314 is connected to a radio frequency transceiver 316. The radio-frequency coil 314 and radio frequency transceiver 316 may be replaced by separate transmit and receive coils and a separate transmitter and receiver. It is understood that the radio-frequency coil 314 and the radio frequency transceiver 316 are representative. The radio-frequency coil 314 is intended to also represent a dedicated transmit antenna and a dedicated receive antenna. Likewise, the transceiver 316 may also represent a separate transmitter and receivers. The radio-frequency coil 314 may also have multiple receive/transmit elements and the radio frequency transceiver 316 may have multiple receive/transmit channels. For example, if a parallel imaging technique such as SENSE is performed, the radio-frequency could 314 will have multiple coil elements.

There is a subject display 330 positioned such that the subject 322 would be able to view images rendered there during operation of the magnetic resonance imaging system 302. The magnetic resonance imaging system may also be configured to provide auditory guidance that is synchronized with and supports the subject display. Additionally, there is a respiratory belt 332 that is used to measure the respiratory phase of the subject 322. For example, the respiratory belt 332 may be used to measure the calibration respiratory data 116. The respiratory belt is representative of a respiratory monitoring system. The respiratory belt could be replaced with a variety of other systems such as a camera system or a pilot tone navigator.

The subject display 330 may be used to render a breathing guide. The subject display 330 is an example of a subject user interface. The subject user interface in other alternatives could provide an auditory signal in addition to or in place of the optical subject display 330.

The transceiver 316, the gradient controller 312, the subject display, 330, the respiratory belt 332, and the subject support actuator 318 are shown as being connected to the hardware interface 106 of the computer system 102.

The memory 110 is further shown as containing a rendering of a breathing guide 340 that would be rendered using the subject display 330 so as to help the subject 322 control breathing during the acquisition of k-space data. The memory 110 is further shown as containing k-space data 342 acquired using the selected magnetic resonance fingerprinting sequence 126. In some instances, the breathing of the subject 322 is controlled or guided with the rendering of the breathing guide 340 on the subject display 330. In other instances, the respiratory data 344 may be acquired during the k-space data 342 and used to either update the rendering of the breathing guide 340 and/or to trigger the acquisition of the k-space data 342.

The memory 110 is further shown as containing a magnetic resonance image 346 that has been reconstructed using the k-space data 342 and the selected magnetic resonance fingerprinting dictionary 128.

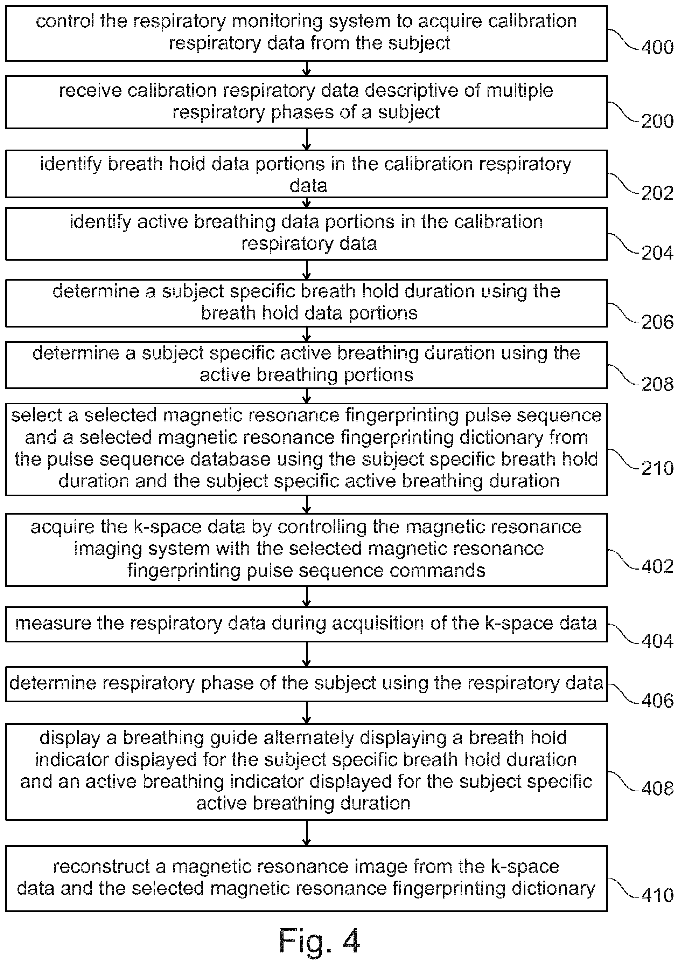

Fig. 4 shows a flowchart which illustrates a method of controlling the medical system 300 of Fig. 3. In step 400, the computational system 104 controls the respiratory monitoring system 332 to acquire the calibration respiratory data 116 from the subject 322. This may, for example, be performed when the gradient coils 310 are activated to cause auditory noise. In other examples, this may be performed before the subject 322 has been inserted into the magnet 304. Steps 200 through 210 are performed as was illustrated in Fig. 2. In step 402, the k-space data 342 is acquired by controlling the magnetic resonance imaging system 302 with the selected magnetic resonance fingerprinting pulse sequence 126. In step 404, the respiratory data 344 is measured during the acquisition of the k-space data 342. In step 406, the respiratory phase of the subject 322 is determined using the respiratory data 344.

This may be done on the fly or in real time as the k-space data is acquired. The acquisition of the k-space data 342 may then be synchronized to the respiratory phase of the subject 322. The measurement of the respiratory data during the acquisition of the k-space data may be used in several different ways to the respiratory data in different examples. In one example the breathing of the subject is guided by the respiratory monitoring system and the acquired k-space data is labeled with the measured respiratory phase. The subject display system cyclically displays the same target breathing pattern determined from the calibration respiratory data, except that in the beginning before starting the acquisition of k-space data, there may be an "adaptive period" where the subject display system step-wise adapts the displayed breathing pattern from the current breathing pattern of the subject to the target breathing pattern. After starting the MRF scan, the subject displays, in some examples, the same cyclical breathing pattern throughout the scan.

Another potential use of the synchronization of the k-space data with the respiratory phase of the subject is that the k-space data may be labeled with a measured respiratory phase of the subject. This may for example be used for retrospective motion correction as well as provide a means of accessing if the k-space data was measured during the breath hold or not: The real-time monitored respiratory signal may be used to give feedback to the subject (thumbs up) if they follow the displayed breathing pattern well.

In step 408, the rendering of the breathing guide 340 is displayed to the subject 322, using the subject display 330 during the acquisition of the k-space data 342. This helps the subject 322 synchronize breathing to the acquisition of the k-space data 342. In step 410, the magnetic resonance image 346 is reconstructed from the k-space data 342 using the selected magnetic resonance fingerprinting dictionary 128, according to a magnetic resonance fingerprinting protocol.

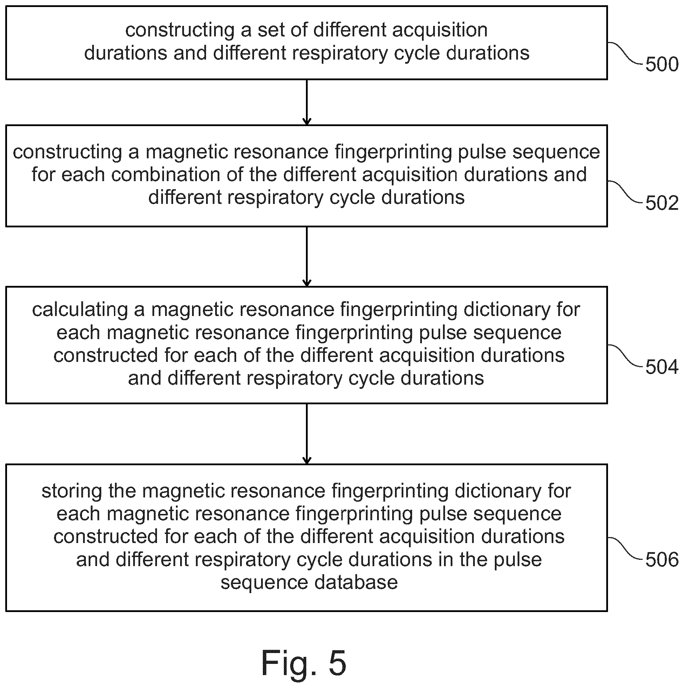

Fig. 5 shows a flowchart which illustrates a method of constructing a pulse sequence database. In step 500, the method comprises constructing a set of different acquisition durations and different respiratory cycle durations. This is formally equivalent to constructing a set of different acquisition durations and different active breathing durations. In step 502, a magnetic resonance fingerprinting pulse sequence is constructed for each combination of the different acquisition durations and different respiratory cycle durations. In step 504, a magnetic resonance fingerprinting dictionary is calculated for each magnetic resonance fingerprinting pulse sequence constructed for each of the different acquisition durations and different respiratory cycle durations. In step 506, the magnetic resonance fingerprinting dictionary and its paired magnetic resonance fingerprinting pulse sequence are stored in the pulse sequence database. This process is repeated multiple times to fill the pulse sequence database.

Magnetic Resonance Fingerprinting (MRF) is a quantitative imaging technique that provides multiple quantitative maps (e.g., T1, T2, and proton density) simultaneously from a single scan. It acquires a series of highly under-sampled images with varying sequence parameters to measure a transient-state MR signal evolution (or 'fingerprint') that depends on tissue-specific quantitative parameters. Using the Bloch equations or extended phase graphs simulation a so-called dictionary is constructed that contains different combinations of quantitative parameter values and the corresponding signal evolutions. By matching a measured signal evolution to an entry in the pre-computed dictionary for each voxel, multiple quantitative maps can be estimated simultaneously.

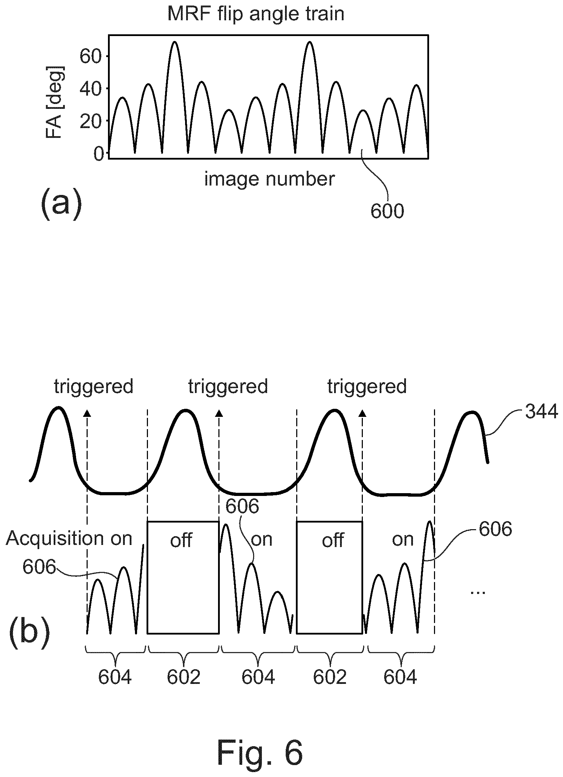

Motion during the MRF acquisition hinders accurate estimation of quantitative maps because motion alters measured signal evolution whereas it is not represented in the simulated dictionary. Although several methods have been suggested to compensate for motion in MRF, most of them are limited to rigid-body in-plane motion. As the respiratory motion is non-rigid and mostly along the through-plane direction for axial acquisitions, retrospectively correcting motion in abdominal MRF remains challenging. On the other hand, there are approaches that prevent motion-related artifacts prospectively for abdominal scans, e.g., breath holds and respiratory triggering. However, for most cases, a series of long breath holds is needed to cover a volume of interest, which could be difficult for some patients. In the respiratory triggering approach, subjects are allowed to breathe freely as data are acquired only while the breath is held (usually an exhale position), but the pre-calculation of the dictionary is not possible due to varying data acquisition windows (i.e., exhale durations) that affect MR signal evolutions (Fig. 6). This makes reconstruction time prohibitively long because the dictionary needs to be calculated for each scan and each slice.

Fig. 6 is used to illustrate the construction of the magnetic resonance fingerprinting pulse sequence. In image A, there is a complete magnetic resonance fingerprinting flip angle train 600. This flip angle train is, however, longer than one breath hold duration of the subject. The complete MRF flip angle train 600 is then broken up into multiple pieces. In image B, the respiratory data 344 is shown. This is divided into active breathing durations 602 and breath hold durations 604. The acquisition of k-space data is only during the breath hold duration 604. The flip train 600 has been broken into multiple flip angle train portions 606. These flip angle train portions 606 are distributed during the breath hold durations 604.

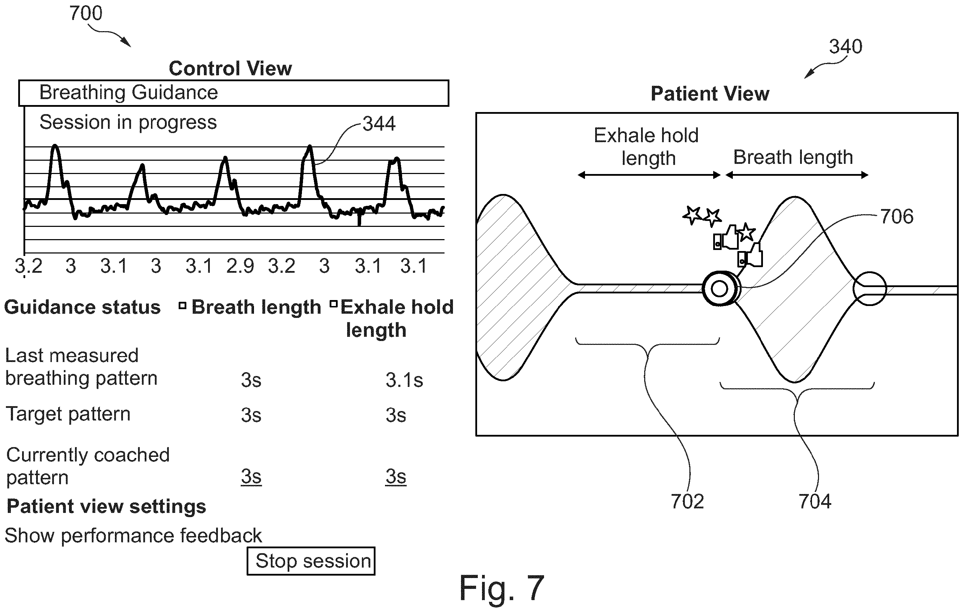

Fig. 7 shows a display of the respiratory data 344 as might be shown to an operator of the medical system 300. Also shown is a rendering of the breathing guide 340 as it might be displayed to the subject 322 on the subject's display 330.

The breathing guide 340 is shown as having a continuous train of breath hold indicators 702 and active breathing indicators 704. In the middle, there is a current position indicator 706 which indicates to the subject 322 at which position in the breathing cycle the subject should be. During the breath hold indicator 702, the subject tries to exhale and hold the breath where during the active breathing indicator 704, the subject is able to inhale and exhale freely.

The in-bore breathing guidance system (subject display 330) guides a patient to follow a predefined breathing pattern using visual and auditive instructions. The breathing pattern is determined by two parameters: (1) breath hold length, during which MRF data are acquired and (2) breath length, during which acquisition is suspended. The optimal breathing parameters are chosen for each patient to maximize patient comfort. Since the breathing pattern is determined before scanning, all the necessary timing information for the MRF dictionary calculation is available in advance. Therefore, in contrast to the standard respiratory triggering approach, dictionaries corresponding to breathing patterns that cover most of the patients can be calculated beforehand, enabling fast reconstruction. In addition, the sequence can be optimized for each breathing pattern to enhance the encoding capability, e.g., by evaluating the noise propagation properties of MRF sequences using a Monte Carlo simulation.

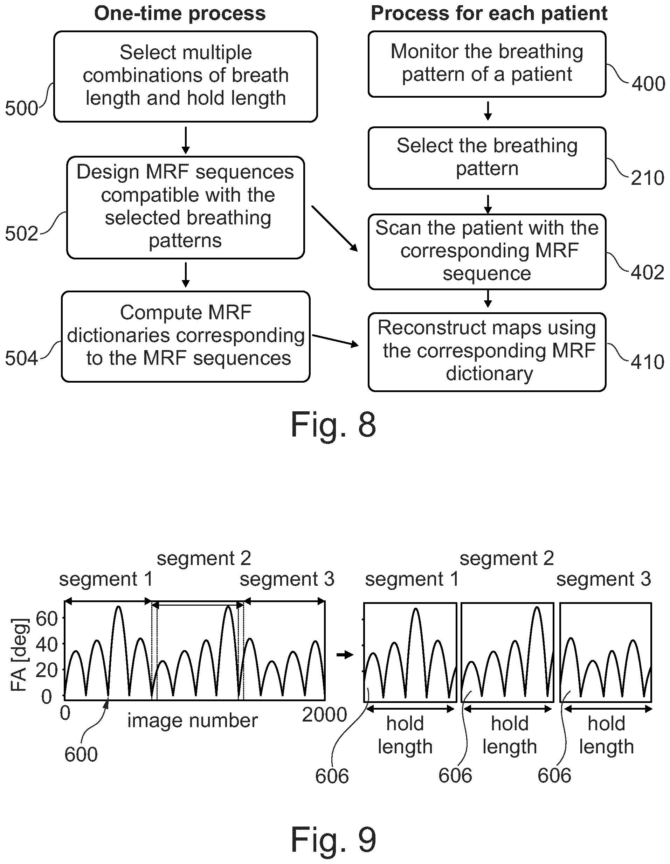

Examples may provide for a means of obtaining MRF maps within reasonably fast reconstruction times while using the breathing guidance system to ensure patient comfort. The essential elements of the invention include the following two procedures (Cf. Fig. 8 below): (1) Several combinations of respiratory cycle length and breath hold length are selected such that they cover the natural breathing patterns of most subjects. For the selected breathing patterns, the corresponding MRF sequences that acquire data only during a held respiratory phase are designed. The MRF dictionaries are then computed for each of these MRF sequences using available timing information. This process is done only once before scanning. (2) For each subject, the breathing signal is monitored and one of the breathing patterns (respiratory cycle length and breath hold length) from (1) is selected accordingly. Then, the corresponding MRF sequence and dictionary are used to acquire data and reconstruct maps. This enables fast reconstruction, which is contrary to the standard respiratory triggering approach where MRF dictionaries cannot be calculated beforehand due to varying respiratory patterns.

Fig. 8 shows a flowchart which illustrates the relationship between the methods illustrated in Figs. 4 and 5. The steps are divided into one-time processes and a process used for each subject. In the one-time process, there is a step 500 of selecting multiple combinations of breath length and hold length. In step 502, a magnetic resonance fingerprint sequence is designed that is compatible with the selected breathing patterns. In step 504, various magnetic resonance fingerprinted dictionaries are calculated corresponding to the MRF sequences calculated in step 502.

In the processes for each patient, there is the monitoring of the breath pattern of a patient in step 400. In step 210, the breathing pattern is selected. In step 402, the patient is scanned with the

corresponding magnetic resonance fingerprinting sequence. In step 410, the MRF maps are reconstructed with the corresponding magnetic resonance fingerprinting dictionary and the acquired k-space data. From this figure it can be seen that if the dictionaries and magnetic resonance fingerprinting sequences are pre-calculated, the steps 500, 502, and 504 in Fig. 5 do not need to be repeated.

In some implementations of constructing a pulse sequence database, a first step is to choose multiple combinations of respiratory cycle length and breath hold length that cover the natural breathing patterns of most subjects. For example, 2-5 secs with steps of 0.5 secs for both breath (exhale) hold length and respiratory cycle length can be used. The next step is to design MRF sequences compatible with the selected breathing patterns.

Fig. 9 illustrates how the complete flip angle train 600 is divided into multiple segments, 604, of a constant breath hold duration or length. First, the original MRF sequence is divided into multiple segments of predefined breath hold length. Here, each sequence segment starts with the minimum flip angle to ensure smooth signal evolutions. The last segment can be optionally filled with additional RF excitations even though the total number of RF shots of the original sequence (2000 in this example) is reached. Although in this example the original MRF sequence was simply divided into multiple segments without any modifications in the sequence parameters, it can be optimized using known timing information to improve the encoding capability.

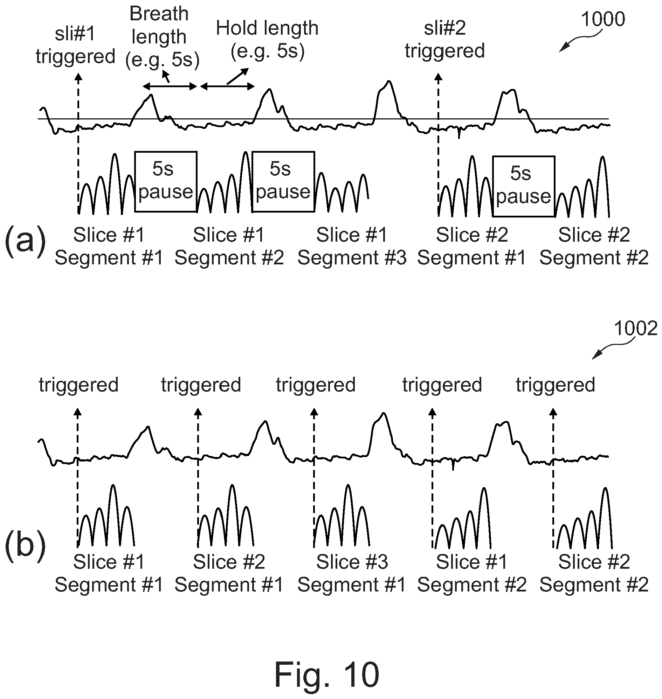

Fig. 10 illustrates two magnetic resonance fingerprinting pulse sequences.

The pulse sequence 1000 illustrates a slice-by-slice magnetic resonance fingerprinting pulse sequence. The pulse sequence 1002 illustrates an interleaved magnetic resonance fingerprinting pulse sequence.

As illustrated in Fig. 10, The sequence segments can be ordered in two ways for multi-slice scans:
(i) Slice-by-slice acquisition (1000)
   All sequence segments for the acquisition of a single slice are performed sequentially before acquiring the next slice (i.e., the outer and inner loop goes through slices and segments, respectively). The data acquisition is triggered for each slice.
(ii) Interleaved acquisition (1002)
   For each segment all slices are acquired first, followed by the acquisition of the next segment (i.e., the outer and inner loop goes through segments and slices, respectively). The data acquisition is triggered for each slice and each segment.

As the acquisition is triggered for the entire slice in (i), if the target breathing pattern is not followed well at the beginning resulting in a shifted trigger time point compared to the target pattern, the data would be corrupted for the entire slice. This problem is mitigated in (ii) because data acquisition is triggered separately for each slice and each segment. On the other hand, the slice-by-slice acquisition is more robust to potential changes in the abdominal position across multiple breath hold phases, since the measurement of all sequence segments for a single slice is performed one after the other, whereas it is interrupted by the measurement of other slices in (ii).

For each of the MRF sequences, the corresponding MRF dictionary may be calculated using the extended phase graph formalism or Bloch equation before scanning to enable fast reconstruction. In (i) inserting acquisition pauses affects the signal evolution. Thus, dictionaries are calculated using both breath hold and respiratory cycle length of a predefined breathing pattern. On the other hand, the signal evolution is not affected by the duration of acquisition pauses (breath length) in (ii) assuming the full relaxation of spins during the acquisition of other slices. Therefore, only the breath hold duration is needed for the calculation of the dictionary.

Once the MRF sequences and dictionaries for the selected combinations of breath length and hold length are available, the procedure for each patient can be conducted (right flow chart in Fig. 8). First, the breathing signal of a patient is monitored either at home or during a previous hospital visit, or more practically, during preparation scans (e.g., scout scan) that are always performed before MRF scans. Based on the breathing signal, breath length and hold length are chosen that make the target breathing pattern most similar to the measured breathing pattern. The hold length could be potentially increased for example by 0.5-2.0 secs to increase scan efficiency, which seems to be no problem for up to 5 secs of hold length for most subjects. The MRF sequence and dictionary corresponding to the chosen breathing pattern are then used to scan the patient and reconstruct maps. Without having to compute the dictionary on the fly, the described approach enables fast reconstruction of MRF maps.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: medical system
- 102: computer
- 104: computational system
- 106: network or hardware interface
- 108: user interface
- 110: memory
- 112: machine executable instructions
- 114: pulse sequence database
- 116: calibration respiratory data
- 118: breath hold data portions
- 120: active breathing data portions
- 122: subject specific breath hold duration
- 124: subject specific active breathing duration
- 126: selected magnetic resonance fingerprinting sequence
- 128: selected magnetic resonance fingerprinting dictionary
- 200: receive calibration respiratory data descriptive of multiple respiratory phases of a subject
- 202: identify breath hold data portions in the calibration respiratory data
- 204: identify active breathing data portions in the calibration respiratory data
- 206: determine a subject specific breath hold duration using the breath hold data portions
- 208: determine a subject specific active breathing duration using the active breathing portions
- 210: select a selected magnetic resonance fingerprinting pulse sequence and a selected magnetic resonance fingerprinting dictionary from the pulse sequence database using the subject specific breath hold duration and the subject specific active breathing duration
- 300: medical system
- 302: magnetic resonance imaging system
- 304: magnet
- 306: bore of magnet
- 308: imaging zone
- 309: field of view
- 310: magnetic field gradient coils
- 312: magnetic field gradient coil power supply
- 314: radio-frequency coil
- 316: transceiver
- 318: subject support actuator
- 320: subject support
- 322: subject
- 330: subject display
- 332: respiratory belt
- 340: rendering of breathing guide
- 342: k-space data
- 344: respiratory data
- 346: magnetic resonance image
- 400: control the respiratory monitoring system to acquire calibration respiratory data from the subject
- 402: acquire the k-space data by controlling the magnetic resonance imaging system with the selected magnetic resonance fingerprinting pulse sequence
- 404: measure the respiratory data during acquisition of the k-space data
- 406: determine the respiratory phase of the subject using the respiratory data
- 408: display a breathing guide alternately displaying a breath hold indicator displayed for the subject specific breath hold duration and an active breathing indicator displayed for the subject specific active breathing duration
- 410: reconstruct a magnetic resonance image from the k-space data and the selected magnetic resonance fingerprinting dictionary
- 500: constructing a set of different acquisition durations and different respiratory cycle durations
- 502: constructing a magnetic resonance fingerprinting pulse sequence for each combination of the different acquisition durations and different respiratory cycle durations
- 504: calculating a magnetic resonance fingerprinting dictionary for each magnetic resonance fingerprinting pulse sequence constructed for each of the different acquisition durations and different respiratory cycle durations
- 506: storing the magnetic resonance fingerprinting dictionary for each magnetic resonance fingerprinting pulse sequence constructed for each of the different acquisition durations and different respiratory cycle durations in the pulse sequence database
- 600: complete flip angle train
- 602: active breathing duration
- 604: breath hold duration
- 606: flip angle train portion
- 700: display of respiratory data
- 702: breath hold indicator
- 704: active breathing indicator
- 706: current position indicator
- 1000: slice-by-slice MRF pulse sequence
- 1002: interleaved MRF pulse sequence

## Claims

1. A medical system (100, 300) comprising:
- a memory (110) storing machine executable instructions (112) and a pulse sequence database (114), the pulse sequence database comprising magnetic resonance fingerprinting pulse sequences (604, 1000, 1002), wherein the magnetic resonance fingerprinting pulse sequences within the pulse sequence database are configured to acquire k-space data discontinuously and have different acquisition durations and different respiratory cycle durations; and
- a computational system (104), wherein execution of the machine executable instructions causes the computational system to:
- receive (200) calibration respiratory data (116) descriptive of multiple respiratory phases of a subject (322);
- identify (202) breath hold data portions (118) in the calibration respiratory data;
- identify (204) active breathing data portions (120) in the calibration respiratory data, wherein pairs of the active breathing data portions and the breath hold data portions form one respiratory cycle duration of the subject;
- determine (206) a subject specific breath hold duration (122) using the breath hold data portions;
- determine (208) a subject specific active breathing duration (124) using the active breathing portions; and
- select (210) a selected magnetic resonance fingerprinting pulse sequence (126) and a selected magnetic resonance fingerprinting dictionary (128) from the pulse sequence database using the subject specific breath hold duration and the subject specific active breathing duration, wherein the selected magnetic resonance fingerprinting pulse sequence and the selected magnetic resonance fingerprinting dictionary is selected such that the acquisition duration is shorter than or equal to the subject specific breath hold duration.

2. The medical system of claim 1, wherein the medical system further comprises a respiratory monitoring system (322) configured for measuring respiratory data (344) descriptive of a respiratory phase of the subject, wherein the medical system further comprises a magnetic resonance imaging system (302) configured for acquiring k-space data descriptive of the subject from an imaging zone, wherein execution of the machine executable instructions further causes the computational system to:
- acquire (402) the k-space data by controlling the magnetic resonance imaging system with the selected magnetic resonance fingerprinting pulse sequence,
- measure (404) the respiratory data during acquisition of the k-space data;
- determine (406) the respiratory phase of the subject using the respiratory data, wherein the acquisition of the k-space data is synchronized to the respiratory phase of the subject.

3. The medical system of claim 2, wherein execution of the machine executable instructions further causes the computational system to control (400) the respiratory monitoring system to acquire the calibration respiratory data from the subject.

4. The medical system of claim 3, wherein execution of the machine executable instructions further causes the computational system to control the magnetic resonance imaging system to move the subject into the magnetic resonance imaging system before acquiring the calibration respiratory data, wherein the magnetic resonance imaging system further comprises a magnetic gradient coil system (310, 312), execution of the machine executable instructions preferably causes the computational system to repeatedly activate the magnetic gradient coil system during measurement of the calibration respiratory data.

5. The medical system of claim 4, wherein execution of the machine executable instructions further causes the computational system to measure the calibration respiration data using the respiratory monitoring system at least partially during a pre scan operation of the magnetic resonance imaging system.

6. The medical system of any one of claims 2 through 5, wherein the medical system further comprises a subject user interface configured for use by the subject during acquisition of the k-space data, wherein execution of the machine executable instructions further causes the computational system to render (408) a breathing guide (340) configured to alternately render an breath hold indicator (702) for the subject specific breath hold duration and an active breathing indicator (704) rendered for the subject specific active breathing duration, wherein execution of the machine executable instruction causes the acquisition of the k-space data to be synchronized with the rendering of the breath hold indicator.

7. The medical system of claim 6, wherein the subject user interface is a subject display, wherein the breathing guide comprises a continuous and alternating chain of the breath hold indicator and the active breathing indicator moving past an indicator (706).

8. The medical system of claim 6 or 7, wherein execution of the machine executable instructions further causes the computational system to:
- determine a current breath hold duration of the subject and a current active breathing duration using the respiratory data;
- perform a step wise adjustment of the rendering of the breath hold indicator and the active breathing indicator such that the current breath hold duration matches the subject specific breath hold duration and such that the current active breathing duration matches the subject specific active breathing duration.

9. The medical system of any one of claims 2 through 7, wherein execution of the machine executable instruction further causes the computational system to:
- continuously measure the respiratory data from the subject;
- trigger acquisition of the k-space data when the subject is detected as reaching an held respiratory phase.

10. The medical system of any one of claims 2 through 8, wherein the pulse sequence database comprises magnetic resonance fingerprinting dictionaries paired with the magnetic resonance fingerprinting pulse sequence, and wherein execution of the machine executable instructions further causes the computational system to reconstruct a magnetic resonance image (346) from the k-space data and the selected magnetic resonance fingerprinting dictionary.

11. The medical system of claim 9, wherein execution of the machine executable instructions further causes the computational system to:
- construct (500) a set of different acquisition durations and different respiratory cycle durations:
- construct (502) a magnetic resonance fingerprinting pulse sequence for each combination of the different acquisition durations and different respiratory cycle durations;
- calculate (504) a magnetic resonance fingerprinting dictionary for each magnetic resonance fingerprinting pulse sequence constructed for each of the different acquisition durations and different respiratory cycle durations; and
- store (506) the magnetic resonance fingerprinting dictionary for each magnetic resonance fingerprinting pulse sequence constructed for each of the different acquisition durations and different respiratory cycle durations in the pulse sequence database.

12. The medical system of any one of claims 2 through 10, wherein the respiratory monitoring system comprises any one of the following: a respiratory belt (344), a breathing tube flow monitor, a camera system, a pilot tone navigator, and combinations thereof.

13. The medical system of any one of the preceding claims, wherein the selected magnetic resonance fingerprinting pulse sequence is configured for performing a multi slice acquisition using a slice-by-slice acquisition (1000) of the k-space data or for performing a multi slice acquisition using an interleaved acquisition (1002) of the k-space data.

14. A method of constructing a pulse sequence database (114), wherein the method comprises:
- constructing (500) a set of different acquisition durations and different respiratory cycle durations:
- constructing (502) a magnetic resonance fingerprinting pulse sequence for each combination of the different acquisition durations and different respiratory cycle durations;
- calculating (504) a magnetic resonance fingerprinting dictionary for each magnetic resonance fingerprinting pulse sequence constructed for each of the different acquisition durations and different respiratory cycle durations; and
- storing (506) the magnetic resonance fingerprinting dictionary for each magnetic resonance fingerprinting pulse sequence constructed for each of the different acquisition durations and different respiratory cycle durations in the pulse sequence database.

15. A computer program comprising machine executable instructions (112) for execution by a computational system (104) and a pulse sequence database (114), the pulse sequence database comprising magnetic resonance fingerprinting pulse sequences (604, 1000, 1002), wherein the magnetic resonance fingerprinting pulse sequences within the pulse sequence database are configured to acquire the k-space data discontinuously and have different acquisition durations and different respiratory cycle durations, wherein execution of the machine executable instructions causes the computational system to:
- receive (200) calibration respiratory data (116) descriptive of multiple respiratory phases of a subject;
- identify (202) breath hold data portions (118) in the calibration respiratory data;
- identify (204) active breathing data portions (120) in the calibration respiratory data, wherein pairs of the active breathing data portions and the breath hold data portions form one respiratory cycle duration of the subject;
- determine (206) a subject specific breath hold duration (122) using the breath hold data portions;
- determine (208) a subject specific active breathing duration (124) using the active breathing portions; and
- select (210) a selected magnetic resonance fingerprinting pulse sequence (126) and a selected magnetic resonance fingerprinting dictionary (128) from the pulse sequence database using the subject specific breath hold duration and the subject specific active breathing duration, wherein the selected magnetic resonance fingerprinting pulse sequence and the selected magnetic resonance fingerprinting dictionary is selected such that the acquisition duration is shorter than or equal to the subject specific breath hold duration.
